# EUROPEAN PATENT APPLICATION

(11) **EP 2 533 421 A1**
(43) Date of publication of application: **12.12.2012**
(21) Application number: 11305719.4
(22) Date of filing: 09.06.2011
(51) Int. Cl.: H03F 3/217

(54) **A method for amplification of a signal using a multi-level modulator, and an amplifying device therefor**

(71) Applicant: Alcatel Lucent, 75007 Paris (FR)
(72) Inventor: Haslach, Christoph, 70178 Stuttgart (DE)
(74) Representative: Kleinbub, Oliver

(57) **Abstract**

The invention concerns a method for amplification of a signal (SA) using at least one multi-level modulator (MLMOD) with N+1 levels, using at least one signal mapper (MAPPER), and using at least one switching power amplifier (SPA1-SPAN), wherein the signal (SA) is modulated in the at least one multi-level modulator (MLMOD) with N+1 levels resulting in a modulated multi-level signal with N+1 levels, said modulated multi-level signal with N+1 levels is divided in N modulated input signals (SD1-SDN) in the at least one signal mapper (MAPPER), said modulated input signals (SD1-SDN) being 2-level signals, said modulated input signals (SD1-SDN) are amplified in the at least one switching power amplifier (SPA1-SPAN) resulting in output signals, and said output signals are combined resulting in an amplified copy of the signal, and an amplifying device therefor.

## Description

### Field of the invention

The invention relates to a method for amplification of a signal using a multi-level modulator with N+1 levels, and switching power amplifiers, and an amplifying device adapted to perform said method.

### Background

In order to support highly efficient switching power amplifiers, signals with continuous amplitude, or multi-level signals, need to be converted into 2-level signals. In general, this transformation is executed by so-called delta sigma modulators (DSM), also called sigma delta modulators, or pulse length modulators (PLM), also called pulse width modulators.

These delta sigma modulators (DSM) or pulse length modulators (PLM) are promising modulator concepts e.g. for highly efficient class-S power amplifiers, i.e. switching power amplifiers, used for the amplification of radio signals to be transmitted over an air interface in a communication network. In principle, they allow for an ideal conversion of signals with continuous amplitude and limited bandwidth to a time continuous 2-level signal. This 2-level signal is suited for switching amplifier stages. The 2-level signal can be reconverted to the continuous amplitude signal e.g. simply by a reconstruction filter after the amplification stage.

Further applications of class-S power amplifiers comprise the supply of electrical power for other devices such as in speed control of electric motors, the use of class-S power amplifiers as audio switching amplifiers, or the use of class-S power amplifiers as brightness control of light sources.

### Summary

Class-S is a very promising technique for future mobile and wireless applications and networks that promises highly energy efficient power amplification of radio signals. Nevertheless, nowadays implementations of class-s amplifiers still suffer from imperfections of the employed components which results in deteriorated energy efficiency. A key aspect in this context is the termination of the filter impedance to the signal spectrum and to the switching power amplifier. If this termination is not perfect, power will be dissipated in the combination of reconstruction filter and switching power amplifier. This power dissipation is connected with the out-of-band spectral components of the input signal of the switching power amplifier. These out-of-band spectral components are generated in the class-S modulator, which can e.g. be a delta sigma modulator (DSM) or a pulse length modulator (PLM), and will be referred to as quantization noise in the following.

A key parameter in this context is the so-called coding efficiency which describes the ratio between in-band power to total power of the signal after the class-S modulator. The coding efficiency should be as high as possible in order to have a high energy efficiency.

The object of the invention is thus to propose a method for amplification of a signal using switching power amplifiers with an increased energy efficiency.

According to the state of the art, a single class-S modulator either feeds a single 2-level switching power amplifier, or several 2-level switching power amplifiers which are used in parallel. In general, the coding efficiency of such arrangements is relatively low, as merely using several switching power amplifiers in parallel does not improve the coding efficiency.

The basic idea of the invention is to use a multi-level modulator with N+1 levels for generation of a modulated multi-level signal with N+1 levels from a signal to be amplified, and to divide the modulated multi-level signal with N+1 levels in N modulated input signals in a signal mapper, said modulated input signals being 2-level signals. The modulated 2-level input signals are subsequently amplified in 2-level switching power amplifiers resulting in output signals, and said output signals are combined resulting in an amplified copy of the signal.

The main advantage of using a multi-level modulator is, that the out-of-band spectral components, i.e. the quantization noise, of the modulated multi-level signal with N+1 levels is reduced compared to a modulated 2-level signal. Thus, by means of first creating a modulated multi-level signal with N+1 levels, which is afterwards divided in N modulated 2-level signals, the coding efficiency can be increased. It is preferable to employ 2-level switching power amplifiers as they have in principle the possibility to achieve 100% efficiency due to the switching characteristic of this class of amplifiers, as the amplifier is either switched fully on or off. This principle possibility to achieve 100% efficiency is the key driver for class-S amplifiers.

In an embodiment of the invention, the multi-level modulator with N+1 levels is a multi-level pulse width modulator, and in a further embodiment, the multi-level modulator with N+1 levels is a multi-level delta sigma modulator.

Further features and advantages are stated in the following description of exemplary embodiments, with reference to the figures, which shows significant details, and are defined by the claims. The individual features can be implemented individually by themselves, or several of them can be implemented in any desired combination.

In the following the invention will be explained further making reference to the attached figures.
Fig. 1 schematically shows an amplifying device with a delta sigma modulator, a switching power amplifier and a filter according to the state-of-the-art.
Fig. 2 schematically shows a switching power amplifier architecture relying on a voltage switched circuit topology according to the state-of-the-art.
Fig. 3 schematically shows a delta sigma modulator according to the state-of-the-art.
Fig. 4 schematically shows a multi-level delta sigma modulator according to the state-of-the-art.
Fig. 5 schematically shows an amplifying device with N parallel switching power amplifiers, with a common multi-level modulator of N+1 levels, with a signal mapper for generating N parallel 2-level switching signals for the N parallel switching power amplifiers, and with a signal combining device according to an embodiment of the invention.
Fig. 6 schematically shows an amplifying device with N parallel switching power amplifiers, with a common multi-level modulator of N+1 levels, with a signal mapper for generating N parallel 2-level switching signals for the N parallel switching power amplifiers, and with application of air combining according to an embodiment of the invention.
Fig. 7 schematically shows an amplifying device with N parallel switching power amplifiers, with a common multi-level modulator of N+1 levels, with a signal mapper for generating N parallel 2-level switching signals for the N parallel switching power amplifiers, and with a signal combining device followed by a filter according to an embodiment of the invention.
Fig. 8 shows exemplarily the correlation between a 5-level digital output signal of a 5-level modulator and 4 output states of a signal mapper for generating 4 parallel 2-level switching signals for 4 parallel switching power amplifiers.

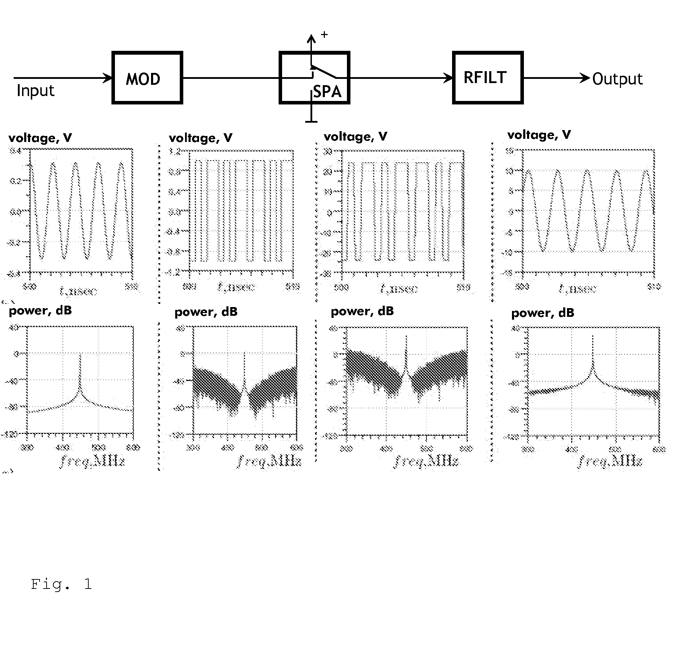

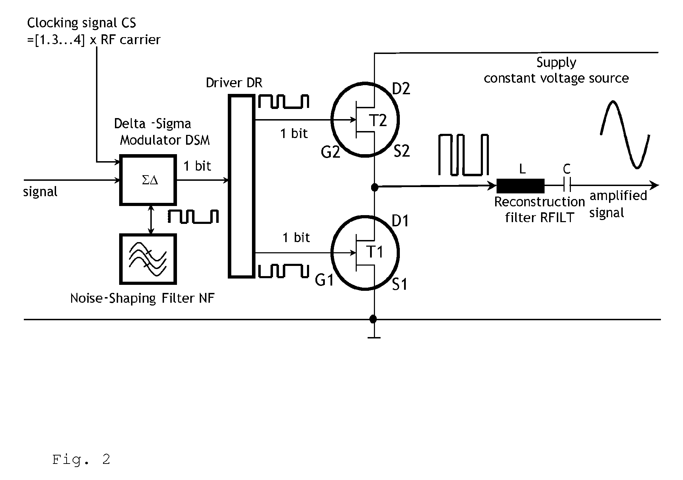

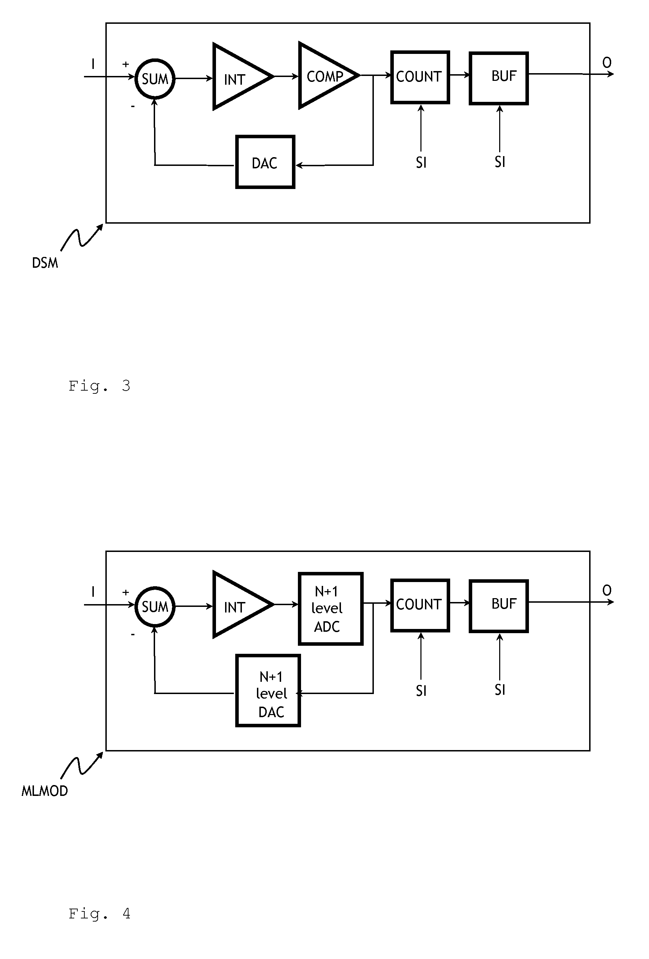

The principle structure of an amplifying device for signal amplification comprising a modulator MOD, a switching power amplifier SPA, and a filter RFILT is depicted in the upper row in fig. 1. The switching power amplifier SPA comprises e.g. a driver and transistors as depicted in more detail in fig. 2. The modulator MOD can be e.g. a delta sigma modulator as depicted in more detail in fig. 3.

The modulator MOD has an input for receiving input signals. The output of the modulator MOD is connected to the input of the switching power amplifier SPA.

The output of the switching power amplifier SPA is connected to the input of the filter RFILT, and the filter RFILT comprises an output for transmitting output signals.

In the middle row, 4 diagrams are showing the signal voltage in volts versus time in nanoseconds from left to right for signals at the input of the modulator MOD, at the output of the modulator MOD, at the output of the switching power amplifier SPA, and at the output of the filter RFILT.

In the lower row, 4 diagrams are showing the signal power density spectrum in dB versus frequency in MHz from left to right for signals at the input of the modulator MOD, at the output of the modulator MOD, at the output of the switching power amplifier SPA, and at the output of the filter RFILT.

As can be seen from the first two diagrams in the middle row, the modulator MOD converts analogue signals into digital 2-level signals, and said digital 2-level signals will be transmitted to the switching power amplifier SPA.

In the third diagram in the middle row, the amplified digital 2-level signal at the output of the switching power amplifier SPA is shown. In order to convert the amplified digital 2-level signals into amplified analogue signals, the filter RFILT is e.g. a reconstruction filter preferably of low pass or band pass type for converting digital signals into analogue signals. The amplified analogue signal is shown in the last diagram in the middle row.

In the following, the basic principle of an amplifying device using a delta sigma modulator as an example of a 2-level modulator and a 2-level switching power amplifier is described, and subsequently the application of 2-level switching power amplifiers with a multi-level delta sigma modulator or with a multi-level pulse width modulator is depicted for two embodiments of the invention.

As an example for such an amplifying device, a voltage switched power amplifier system according to the state-of-the-art is shown in fig. 2. Such a voltage switched power amplifier system comprises a delta sigma modulator DSM with inputs for reception of an analogue radio frequency input signal, and for reception of a clocking signal CS. An output of the delta sigma modulator DSM is connected to an input of a driver DR.

Preferably, the delta sigma modulator DSM is connected to a noise-shaping filter NF or comprises a noise shaping filter.

A first output of the driver DR is connected to the gate G1 of a first transistor T1, and a second output of the driver DR is connected to the gate G2 of a second transistor T2.

The source S1 of the first transistor T1 is connected to ground, and the source S2 of the second transistor T2 is connected to the drain D1 of the first transistor T1.

The drain D1 of the first transistor T1 and the source S2 of the second transistor T2 are connected to an output for amplified radio frequency signals, via a reconstruction filter RFILT that comprises an inductor L and a capacitor C in series. There are variants of the L-C filter topology which however are of no importance for the invention as disclosed.

The drain D2 of the second transistor T2 is connected to the supply of a constant voltage source.

In a method for signal amplification using a voltage switched power amplifier system according to the state-of-the-art as shown in fig. 2, analogue radio frequency input signals, are sent to the delta sigma modulator DSM. Furthermore, clocking signals with e.g. a multiple of the radio frequency carrier frequency are sent to the delta sigma modulator DSM.

In the delta sigma modulator DSM, the analogue radio frequency input signals, are converted into digital 1-bit or higher, e.g. N+1 levels, resolution signals. The sampling rate is determined by the received clocking signals. The digital 1-bit, or N+1 levels, signals are provided at the output of the delta sigma modulator DSM.

Preferably, the noise shaping filter NF is used to minimize quantization error by means of shifting quantization noise into frequency ranges that are less or not relevant for signal processing.

Said digital 1-bit, or N+1 levels, signals are sent to the driver DR that generates first driver signals based on the digital 1-bit signals and second driver signals based on the inverted digital 1-bit signals. The first driver signals are sent to the gate G2 of the second transistor T2, and the second driver signals are sent to the gate G1 of the first transistor T1. The output signals of the driver DR are thus in antiphase which means if the first transistor T1 is on, the second transistor T2 is off and vice versa. The described amplifier architecture with two transistors T1, T2 is just an example, and in alternative architectures, only one, as e.g. in Class J amplifiers, or more than two transistors are used, which has however no influence on the invention. In the latter case, such alternative architectures are e.g. multibit architectures, using two transistors more per each bit more.

The capacitor C and the inductor L together build a reconstruction filter RFILT used to generate smooth analogue output signals that are provided at the output for amplified radio frequency signals.

Fig. 3 is illustrating a delta sigma modulator DSM with 2 levels according to the state-of-the-art. The delta sigma modulator DSM comprises a summer SUM, an integrator INT, a comparator COMP, a digital-to-analogue converter DAC, a counter COUNT, and a buffer BUF.

The summer SUM has a first input for receiving analogue input signals I.

The output of the summer SUM is connected to the input of the integrator INT, and the output of the integrator INT is connected to the input of the comparator COMP.

The output of the comparator COMP is connected both to the input of the digital-to-analogue converter DAC, and to the input of the counter COUNT.

The output of the digital-to-analogue converter DAC is connected to a second inverting input of the summer SUM.

The output of the counter COUNT is connected to the input of the buffer BUF, and the output of the buffer BUF can e.g. be connected to an external device, as e.g. the driver DR of the switching power amplifier in fig. 2, for transmitting modulated digital 2-level output signals 0.

In principle, e.g. an analogue radio frequency input signal I is encoded in the delta sigma modulator DSM into a 2-level digital output sequence that is appropriate for driving a switched output stage of a switching power amplifier.

In the integrator INT, the input signal I is integrated and sent to the comparator COMP. If the comparator COMP detects, that the integrated input signal is above a predefined threshold, then a pulse is triggered and sent both to the counter COUNT and to the digital-to-analogue converter DAC.

In the digital-to-analogue converter DAC, the pulse is converted into an analogue signal, and said analogue signal is subtracted from the input signal I, bringing the integrated input signal below the predefined threshold.

The counter COUNT is incremented with each pulse generated by the comparator COMP during a summing interval SI, which is a predefined time interval. The count at the expiry of the summing interval SI is sent to the buffer BUF, and the counter COUNT is reset. The buffer BUF provides the counts as modulated digital 2-level output signals O at its output e.g. for driving a switched output stage of a switching power amplifier.

According to the invention, a multi-level modulator with N+1 levels, as e.g. a multi-level delta sigma modulator, or a multi-level pulse width modulator, is used for generation of a modulated multi-level signal with N+1 levels.

Fig. 4 schematically shows a multi-level delta sigma modulator according to the state-of-the-art.

The principle structure of the multi-level delta sigma modulator MLMOD depicted in fig. 4 corresponds to the delta sigma modulator DSM with 2 levels as depicted in fig. 3. Thus, in the following only the differences of the multi-level delta sigma modulator MLMOD with respect to the delta sigma modulator DSM with 2 levels depicted in fig. 3 are described.

The 2-level delta sigma modulator DSM can be extended to the multi-level delta sigma modulator MLMOD by replacing the comparator COMP depicted in fig. 3, which can be interpreted as a 1 bit analogue-to-digital converter, by a N+1 level analogue-to-digital converter ADC, and by replacing the digital-to-analogue converter DAC depicted in fig. 3 by a N+1 level digital-to-analogue converter DAC. In a digital implementation, the output of the N+1 level analogue-to-digital converter ADC can be represented in digital values, e.g. as a byte. In an analogue implementation, the output of the N+1 level analogue-to-digital converter ADC can be an analogue signal with discrete amplitude levels.

Multi-level modulators are e.g. described in more detail in the paper "Multi-Level Asynchronous ΣΔ Modulators for Wideband Switching Power Amplifiers" from Albert Garcia i Tormo et al., Department of Electronic Engineering (DEE), Technical University of Catalunya (UPC), 08034 Barcelona, Spain, IEEE 2010.

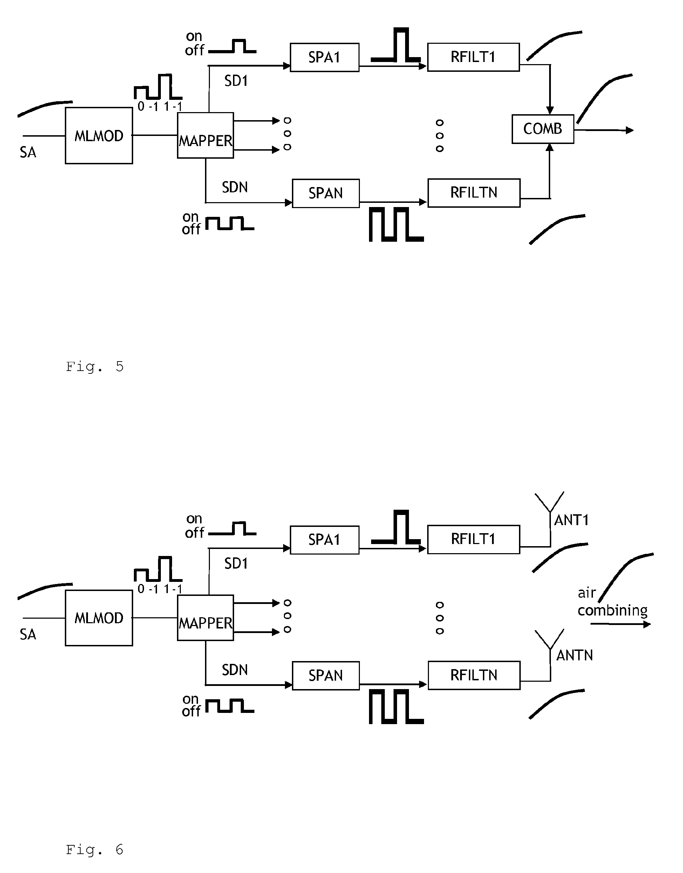

Fig. 5 schematically shows an amplifying device with a multi-level modulator MLMOD with N+1 levels, a signal mapper MAPPER, N switching power amplifiers SPA1-SPAN, N filters RFILT1-RFILTN, and a signal combining device COMB for combining amplified and filtered output signals according to an embodiment of the invention.

The multi-level modulator MLMOD has an input for receiving input signals, and an output connected to an input of the signal mapper MAPPER. The signal mapper MAPPER is connected to the N switching power amplifiers SPA1-SPAN via N outputs.

Each of the N switching power amplifiers SPA1-SPAN is connected to one of the N filters RFILT1-RFILTN, and the N filters RFILT1-RFILTN are in turn connected to the combining device COMB.

The N switching power amplifiers SPA1-SPAN are e.g. switching power amplifiers as depicted and described under fig. 2.

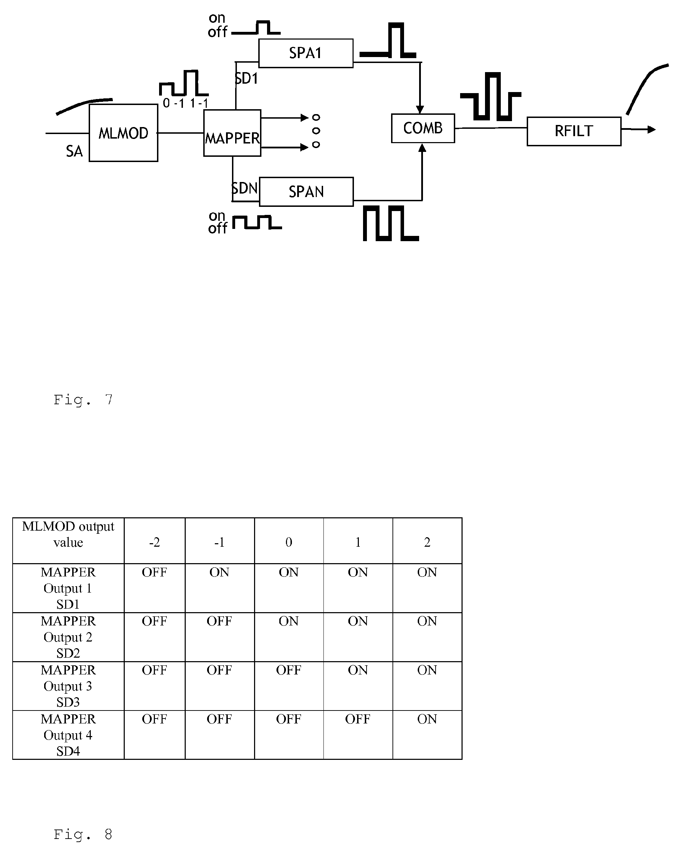

The signal mapper MAPPER receives a discrete value from the multi-level modulator MLMOD with N+1 levels and maps it to N binary switching signals, e.g. by setting N output ports to "ON" or "OFF" level. This can be implemented as a table lookup. The table in fig.8 shows an example for such a table for the case N=4 and will be described below.

In a method for signal amplification using an amplifying device according to the invention as shown in fig. 5, an analogue input signal SA is sent to the input of the multi-level modulator MLMOD. In the multi-level modulator MLMOD, a multi-level digital signal with N+1 levels is generated from the analogue input signal SA, which is sent to the input of the signal mapper MAPPER.

The signal mapper MAPPER generates N parallel 2-level switching signals SD1-SDN from each output symbol of the multi-level modulator MLMOD. E.g. if the multi-level modulator MLMOD with N+1 levels, with N being an even number, has output values [-K=N/2, -K+1, ...0 ... K+1, K=N/2] and an output sample of this modulator has a value m, the signal mapper MAPPER generates N parallel signals, where N/2+m samples correspond to the ON-state, and N/2-m output samples correspond to OFF-state. As already mentioned above, due to the usage of a multi-level modulator MLMOD, the out-of-band spectral components, i.e. the quantization noise, of the modulated multi-level signal with N+1 levels is reduced compared to modulated 2-level signals. Thus, by means of first creating a modulated multi-level signal with N+1 levels, which is afterwards divided in N modulated 2-level signals, the coding efficiency can be increased, while further employing binary switching amplifiers.

In the embodiment depicted in fig. 5, as an example 4 symbols of a 3-level signal with the levels 0, -1, 1, -1 are depicted at the output of the multi-level modulator MLMOD. As in this example N corresponds to 2, 2 parallel 2-level switching sig-nals SD1 and SD2 are generated in the signal mapper MAPPER with the order off, off, on, off for the first 2-level switching signal SD1, and with the order on, off, on, off for the second 2-level switching signal SD2.

The N parallel 2-level switching signals SD1-SDN are amplified in the respective parallel switching power amplifier SPA1-SPAN, and then filtered in the respective filter RFILT1-RFILTN resulting in analogue output signals.

In the combining device COMB, the N analogue output signals are combined, which leads to a superposition of the output signals, resulting in an amplified copy of the analogue input sig-nal SA having a higher coding efficiency compared to an amplification performed by an amplifying device according to the state-of-the-art e.g. depicted in fig. 1.

Fig. 6 schematically shows an amplifying device with a multi-level modulator MLMOD with N+1 levels, a signal mapper MAPPER, N switching power amplifiers SPA1-SPAN, N filters RFILT1-RFILTN, and N antenna networks ANT1-ANTN for air combining of amplified and filtered output signals according to an embodiment of the invention.

The basic structure of the amplifying device is similar to the structure of the amplifying device depicted in fig. 5 and described above. Thus, the only difference compared to the amplifying device depicted in fig. 5 is, that instead of a combining device COMB for combining amplified and filtered output signals as depicted in fig. 5, the embodiment depicted in fig. 6 comprises N antenna networks ANT1-ANTN for air combining of N amplified and filtered output signals.

Fig. 7 schematically shows an amplifying device with a multi-level modulator MLMOD with N+1 levels, a signal mapper MAPPER, N switching power amplifiers SPA1-SPAN, a signal combining device COMB for combining amplified output signals, and a filter RFILT for filtering the amplified and combined output signals according to an embodiment of the invention.

The basic structure of the amplifying device is similar to the structure of the amplifying device depicted in fig. 5 and described above. The only difference compared to the amplifying device depicted in fig. 5 is, that instead of first filtering the amplified output signals in the filters RFILT1-RFILTN, and then combining the amplified and filtered output signals in the combining device COMB as depicted in fig. 5, in the embodiment depicted in fig. 7 first the amplified output signals are combined in the combining device COMB, and then the combined output signals are filtered in the filter RFILT.

Fig. 8 shows exemplarily the correlation between a 5-level digital output signal of a 5-level modulator MLMOD and the values of the 4 output signals of a signal mapper MAPPER for generating 4 parallel 2-level switching signals SD1-SD4 for 4 parallel switching power amplifiers SPA1-SPA4 applicable e.g. to one of the embodiments in fig. 5, 6 or 7.

The signal mapper MAPPER receives a discrete value from the multi-level modulator MLMOD with 5 levels -2, -1, 0, 1 and 2, as depicted in the first row in fig. 8, and maps the 5 levels to 4 binary switching signals SD1-SD4, e.g. by setting 4 output ports to "ON" or "OFF" level. This can be implemented as a table lookup as shown in fig. 8.

In the second column, the level -2 of the multi-level modulator MLMOD is mapped to 4 output ports SD1-SD4 with "OFF" level.

In the third column, the level -1 of the multi-level modulator MLMOD is mapped to one output port SD1 with "ON" level, and to 3 output ports SD2-SD4 with "OFF" level.

In the fourth column, the level 0 of the multi-level modulator MLMOD is mapped to two output ports SD1, SD2 with "ON" level, and to 2 output ports SD3, SD4 with "OFF" level.

In the fifth column, the level 1 of the multi-level modulator MLMOD is mapped to three output ports SD1-SD3 with "ON" level, and to 1 output port SD4 with "OFF" level.

In the sixth column, the level 2 of the multi-level modulator MLMOD is mapped to four output ports SD1-SD4 with "ON" level.

In the embodiments described above, the filters RFILT and RFILT1-RFILTN preferably are reconstruction filters for generation of smooth analogue output signals. However, also duplex filters can be used for the filters RFILT1-RFILTN.

In alternatives of the embodiments described above, instead of an analogue input signal SA, a sampled, digitized input signal is used, with each signal sample being represented by e.g. 14 bits.

In further alternatives of the embodiments described above, instead of having several parallel switching power amplifiers SPA1-SPAN, only one common switching power amplifier with several inputs for the modulated input signals SD1-SDN can be used. Furthermore, said common switching power amplifier may comprise the filters RFILT1-RFILTN and the signal combining device COMB.

The amplifying devices described in the embodiments above can be used in a base station for the transmission of signals from the base station to a user terminal in a communication network, however the invention is also applicable for transmission of signals from an arbitrary transmitting device to an arbitrary receiving device, as e.g. used in a point-to-point radio system or used for connection of devices within a rack.

## Claims

1. A method for amplification of a signal (SA) using at least one multi-level modulator (MLMOD) with N+1 levels, using at least one signal mapper (MAPPER), and using at least one switching power amplifier (SPA1-SPAN), wherein
• the signal (SA) is modulated in the at least one multi-level modulator (MLMOD) with N+1 levels resulting in a modulated multi-level signal with N+1 levels,
• said modulated multi-level signal with N+1 levels is divided in N modulated input signals (SD1-SDN) in the at least one signal mapper (MAPPER), said modulated input signals (SD1-SDN) being 2-level signals,
• said modulated input signals (SD1-SDN) are amplified in the at least one switching power amplifier (SPA1-SPAN) resulting in output signals,
• and said output signals are combined resulting in an amplified copy of the signal.

2. A method according to claim 1, wherein said at least one multi-level modulator (MLMOD) is a multi-level pulse width modulator.

3. A method according to claim 1, wherein said at least one multi-level modulator (MLMOD) is a multi-level delta sigma modulator.

4. A method according to any of the preceding claims, wherein said output signals are combined by means of air combining.

5. A method according to any of the claims 1 to 3, wherein said output signals are combined in a signal combining device (COMB).

6. A method according to any of the preceding claims, wherein at least one filter (RFILT1-RFILTN) is used to generate analogue output signals before or after combination of said output signals.

7. An amplifying device for amplification of signals (SA), said amplifying device comprising at least one multi-level modulator (MLMOD) with N+1 levels, at least one signal mapper (MAPPER), and at least one switching power amplifier (SPA1-SPAN), wherein
• said at least one multi-level modulator (MLMOD) with N+1 levels is adapted to modulate a signal (SA) resulting in a modulated multi-level signal with N+1 levels,
• said at least one signal mapper (MAPPER) is adapted to divide the modulated multi-level signal with N+1 levels in N modulated input signals (SD1-SDN), said modulated input signals (SD1-SDN) being 2-level signals,
• and said at least one switching power amplifier (SPA1-SPAN) is adapted to amplify said modulated input signals (SD1-SDN) resulting in output signals.

8. An amplifying device according to claim 7, said amplifying device comprising a signal combining device (COMB) for combining said output signals resulting in an amplified copy of the signal.

9. A base station for mobile communication comprising an amplifying device according to claim 7 and at least one antenna network (ANT1-ANTN) for transmission of said amplified signals over an air interface.
